# EUROPEAN PATENT SPECIFICATION

(11) **EP 4 333 073 B1**
(45) Date of publication and mention of the grant of the patent: **12.08.2026**
(21) Application number: 23182331.1
(22) Date of filing: 29.06.2023
(51) Int. Cl.: H10D 30/66, H10D 8/60, H10D 30/01, H10D 64/68, H10D 62/832

(54) **SIC-BASED ELECTRONIC DEVICE WITH IMPROVED GATE DIELECTRIC AND MANUFACTURING METHOD THEREOF, DIODE**
SIC-BASIERTE ELEKTRONISCHE VORRICHTUNG MIT VERBESSERTEM GATE-DIELEKTRIKUM UND HERSTELLUNGSVERFAHREN DAFÜR, DIODE
DISPOSITIF ÉLECTRONIQUE À BASE DE SIC À DIÉLECTRIQUE DE GRILLE AMÉLIORÉ ET SON PROCÉDÉ DE FABRICATION, DIODE

(30) Priority: 29.08.2022 IT 202200017730
(43) Date of publication of application: 06.03.2024
(73) Proprietor: STMicroelectronics S.r.l., 20864 Agrate Brianza (MB) (IT)
(72) Inventor: FIORENZA, Patrick, 95032 Belpasso (CT) (IT); ROCCAFORTE, Fabrizio, 95030 Mascalucia (CT) (IT); ZANETTI, Edoardo, 95028 Valverde (CT) (IT); SAGGIO, Mario Giuseppe, 95020 Aci Bonaccorsi (CT) (IT)
(74) Representative: Studio Torta S.p.A.

(56) References cited:
- JP-A- 2004 193 288
- US-A1- 2007 045 631
- US-A1- 2015 179 744
- US-B2- 11 316 025
- US-B2- 8 981 460

## Description

The present invention relates to an electronic device, in particular a power MOSFET or a Schottky diode, and to a manufacturing method of the electronic device.

As is known, semiconductor materials having a wide bandgap, in particular having a high value of the bandgap, low on-state resistance (R_{ON}), high value of thermal conductivity, high operating frequencies and high saturation velocity of charge carriers, are ideal for producing electronic components, such as diodes or transistors, in particular for electrical applications. A material having said characteristics, and adapted to be used for manufacturing electronic components, is silicon carbide (SiC). In particular, silicon carbide, in its different polytypes (e.g., 3C-SiC, 4H-SiC, 6H-SiC), is preferable to silicon as regards the properties listed above.

The hexagonal SiC polytype (4H-SiC) is by far the most studied polytype and mass production of 4H-SiC wafers are currently commercially available, albeit at a higher cost than typical silicon wafers. The 3C-SiC has a significant cost advantage over 4H-SiC as it may be grown directly on Si by CVD deposition. The availability of 3C-SiC epitaxial layers of good quality of Silicon enables the implementation of cost-effective SiC-based power devices, for example adapted to work in the interval 650V - 1200V.

Electronic devices provided with a silicon carbide substrate, compared to similar devices provided with a silicon substrate, have further advantages, such as low output resistance in conduction, low leakage current, and high operating frequencies. In particular, SiC Schottky diodes have demonstrated higher switching performances, making SiC electric devices particularly favorable for high-frequency applications.

Numerous scientific papers have also reported good switching performances of silicon carbide (SiC) MOSFET devices. From an industrial point of view, in addition to switching performances, SiC MOSFET devices also have good structural robustness which is a desirable characteristic in power systems.

A relevant structural element in SiC (in particular 4H-SiC) MOSFET devices is the gate dielectric (or oxide). The properties of the gate dielectric (permittivity, fixed charges, etc.) and the dielectric/SiC interface quality (interface state density Dᵢₜ, near interface oxide traps, NIOTs) have a significant impact on relevant parameters of the MOSFET, such as the field effect channel mobility µ_{FE}, the ON-state resistance and the threshold voltage Vₜₕ. Therefore, the gate dielectric optimization is the prerequisite for fully exploiting the performances of SiC MOSFETs.

Furthermore, in designing a MOSFET, a solution should be found to overcome the undesired reduction of the Vₜₙ when the on-state resistance is decreased. In particular, a solution is desirable to increase the Vₜₕ while maintaining a low on-state resistance.

Silicon oxide (SiO₂) is commonly used in commercial SiC MOSFETs as a gate dielectric, owing to the ease of manufacturing by thermal oxidation of SiC. However, the oxidation rate of SiC is lower than that of Silicon and the interface state density is of about 2-3 orders of magnitude higher than that of the SiO₂/Si stack. To reduce the interface state density Dᵢₜ and improve the channel mobility µ_{FE} of 4H-SiC MOSFETs that use SiO₂ as gate dielectric, a post-oxidation annealing (POA) or post-deposition annealing (PDA) step is typically performed in environments rich in nitrogen (N₂O, NO). However, thermal oxidation of SiC, as well as POA and PDA processes, typically require high temperatures (> 1100°C) and long annealing times (up to 8 hours in some cases). Furthermore, all these processes lead to the formation of a "disordered" region at the SiO₂/SiC interface as a consequence of the inevitable interfacial reoxidation that occurs during high-temperature annealing with NO or N₂O. This disordered interface is characterized by the presence of SiOₓ and C non-stoichiometric defects, which have a negative effect on both channel mobility and stability of the threshold voltage (Vₜₙ).

Furthermore, due to the low permittivity of SiO₂ compared to 4H-SiC, under high-voltage operating conditions the electric field inside the SiO₂ is about 2.5 times higher than that of SiC. Therefore, when the electric field reaches the critical field of 4H-SiC (which is about 3-4 MV/cm), the SiO₂ gate dielectric, according to Gauss's law, is subject to an electric field of about 2.3 times greater, i.e. about 7-9 MV/cm. Therefore, the SiO₂ dielectric will be under high-stress and poor-reliability conditions.

According to a solution known to the Applicant, in order to reduce the thermal budget necessary for the SiC oxidation, the SiO₂ layers deposited by CVD may be used as gate insulators in SiO₂ MOSFETs.

According to a solution known to the Applicant, high-permeability dielectrics (such as Al₂O₃, HfO₂, La₂O₃) have been proposed to attenuate the electric field in the gate insulator. However, in this process, a SiO₂ layer may form at the interface, resulting in the creation of carbon-related defects (such as vacancies, interstitials, C-C dimers, carbon clusters, etc.) which may give rise to instability of the voltage V_{FB} (flat-band voltage) in MOSCAPs ("Metal Oxide Semiconductor Capacitors").

According to a solution known to the Applicant, Al₂O₃ films have been proposed as gate insulators to adjust the Vₜₕ value in the SiC MOSFETs. High-k insulators (known as "high-k" materials) may be used, in particular, to increase the Vₜₕ value in on-state in SiC MOSFETs. However, the integration of high-k dielectrics is limited by their susceptibility to crystallization phenomena at the thermal budgets required for forming contacts in SiC devices (> 800°C). Furthermore, the bandgap of the insulators decreases as their permittivity increases; consequently, the choice of a simple high-k generally causes a small band-offset with SiC and, consequently, a high leakage current.

Patent document US8981460B2 presents power semiconductor devices, and methods for manufacture thereof, with improved ruggedness. Patent document JP 2004 193288 A discloses a planar gate vertical MOSFET with a multilayer gate insulator made of ONO (oxide/nitride/oxide). Patent document US11316025B2 relates to an electronic device, in particular a power MOSFET or a Schottky diode, and to a method for manufacturing the electronic device. However, the above-mentioned issues are not solved.

The need is therefore felt to provide a solution to the problems set forth above.

According to the present invention, an electronic device and a manufacturing method thereof are provided, as defined in the attached claims.

For a better understanding of the present invention, preferred embodiments thereof are now described, purely by way of non-limiting example, with reference to the attached drawings, wherein:
- Figure 1 illustrates, in lateral sectional view, a MOSFET device according to an aspect of the present invention;
- Figure 2 illustrates an enlarged detail of a stack which forms the gate dielectric of the device of Figure 1, according to an aspect of the present invention;
- Figure 3 illustrates, by a block diagram, steps of a manufacturing process of the device of Figure **1****;** and
- Figure 4 illustrates, in lateral sectional view, a Schottky diode according to a further aspect of the present invention.

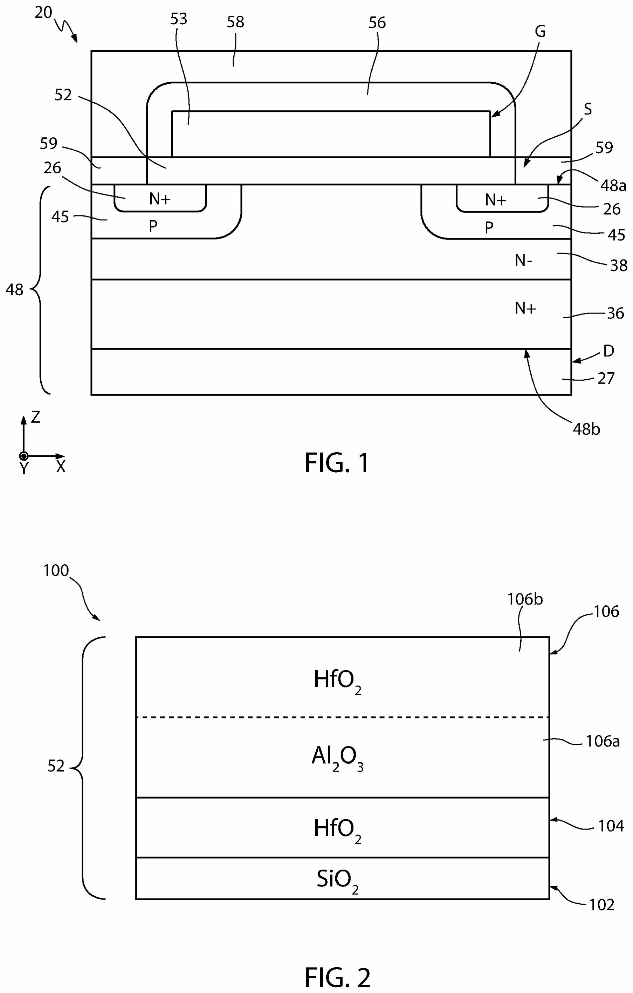

Figure 1 illustrates, in sectional view in a Cartesian (triaxial) reference system of axes X, Y, Z, a transistor 20, in particular a vertical-channel MOSFET, even more in particular a power MOSFET, according to an aspect of the present invention. The transistor 20 comprises: a gate terminal G (forming a control terminal) coupeable, in use, to a generator of a biasing voltage V_{GS}; a first conduction terminal S, including a source region 26 (N-type implanted region) and a source metallization 59 (for example of Nickel, which forms an ohmic electrical contact with the source region 26); and a second conduction terminal D or drain region D (including a drain metallization 27, for example of Nickel, which forms an ohmic electrical contact). In use, with suitable biasing, a conductive channel of majority carriers (here, electrons) is established between the source region 26 and the drain region 27, producing a current flow.

In greater detail, the transistor 20 comprises a semiconductor body 48, in particular of SiC, having a first and a second face 48a, 48b opposite to each other along the direction of the Z axis. In particular, in the present embodiment, the term "semiconductor body" means a structural element or solid body that may comprise one or more epitaxial layers grown on a base substrate. In particular, Figure 1 illustrates a semiconductor body 48 including a base substrate 36 having an epitaxially grown structural layer 38 extending thereon, acting as a drift layer. The substrate 36 has a first conductivity, here of N-type, and doping for example comprised between 1.10¹⁸ cm⁻³ and 5.10¹⁹ cm⁻³. The structural layer 38 has the first conductivity, here of N-type, and lower doping than that of the substrate 36, for example comprised between 1·10¹⁴ cm⁻³ and 5·10¹⁶ cm⁻³.

According to one aspect of the present invention, the polytype of the semiconductor body 48 is the cubic polytype of Silicon Carbide, or 3C-SiC. Alternatively, and according to a further aspect of the present invention, the polytype of the semiconductor body 48 is 4H-SiC. However, the present invention also finds application for further and different silicon carbide polytypes.

The gate terminal G extends on the first face 48a of the semiconductor body 48; a body region 45, having a second conductivity opposite to the first conductivity (here, a P-type implanted region), extends into the semiconductor body 48 (more in particular, into the structural layer 38) at (facing) the first face 48a; the source region 26, having the first conductivity, extends into the body region 45 at (facing) the first surface 48a; and the drain metallization 27 extends at the second face 48b of the semiconductor body 48. The transistor 20 is therefore of vertical-conduction type (i.e., the conductive channel extends along a main direction which is along the Z axis).

The gate terminal G includes a gate metallization 53, and a gate dielectric 52. The gate metallization 53 extends on the gate dielectric 52.

According to the present invention, the gate dielectric 52 is a stack, 100 including a plurality of superimposed layers, as illustrated in Figure 2 and described hereinbelow with reference to this Figure.

An insulating, or dielectric, layer 56 extends on the gate region 24 and is, in particular, of silicon dioxide (SiO₂) or silicon nitride (SiN) with a thickness, measured along the Z axis, comprised between 0.5 µm and 1.5 µm. Furthermore, a source terminal 58, in particular of metal material, for example Aluminum, with a thickness, measured along the Z axis, comprised between 0.5 µm and 2 µm, extends in proximity of the insulating layer 56.

The source terminal 58 extends up to contacting the source region 26, possibly through an ohmic contact region 59, optional.

The metal layer 27, for example of Ti/Ni/Au, which forms the gate terminal D, extends on the second face 48b of the semiconductor body 48. An interface layer to allow the ohmic contact, not shown, for example of nickel silicide, may be present between the semiconductor body 48 and the metal layer 27.

With reference to the gate dielectric 52 and to Figure 2, the stack that forms, as a whole, the gate dielectric 52 is designed in such a way as to have a high density of electron traps (in particular, configured to trap electrons from the semiconductor body 48, in particular at the first face 48a), inducing or increasing the negative charge density inside the gate dielectric (in particular in the layer 104), during use.

The presence of a net negative charge in the gate dielectric 52 allows balancing the positive charges at the interface between the gate dielectric 52 and the semiconductor body 48 (i.e., at the first face 48a) and thus allows improving the operations of the device 20.

In particular, the stack 100 is an insulating multilayer which has at least an energy level that is in energetic proximity (e.g., between 0 eV and 2 eV) of the conduction band of the semiconductor material (e.g., SiC) of the body 48.

In one embodiment, the stack 100 comprises: a first insulating layer 102, in particular of Silicon Oxide (SiO₂); a second insulating layer 104 on the first insulating layer 102, in particular of Hafnium Oxide (HfO₂); a third insulating layer 106 on the second insulating layer 104, in particular of an alloy including aluminum (e.g.: Al₂O₃, AlN, AlON). In one embodiment, the third insulating layer 106 is formed by a plurality of (e.g., two) sub-layers 106a, 106b, wherein the sub-layer 106a is of Aluminum Oxide (e.g., Al₂O₃) and the sub-layer 106b is of a Hafnium Oxide (e.g., HfO₂).

Variants to what has been described above are possible, in particular the first insulating layer 102 may alternatively be of Al₂O₃, SiN or AlN; the second insulating layer 104 may alternatively be of HfSiOₓ, ZrO₂, ZrSiOₓ; the sub-layer 106a of the third insulating layer 106 may alternatively be of AlSiOₓ and/or the sub-layer 106b may alternatively be of HfSiOₓ.

The insulating layer 102 has a reduced thickness to allow the tunneling of the electrons from the semiconductor body 48 and has a bandgap greater than the bandgap of the insulating layer 104. The insulating layer 102 therefore has a thickness such that it may be traversed by tunnel effect by the electrons which, confined in the potential well and in a number limited by the states allowed by the well, produce a positive Vₜₕ of the MOSFET 20.

The layer which acts as a trap for the electric charges is the insulating layer 104, with a reduced bandgap, which forms a quantum-well between the insulating layer 102 and the insulating layer 106. In one embodiment, the hafnium oxide represents a potential well for the electrons confined on one side by the insulating layer 102 and on the other side by the insulating layer 106.

The insulating layer 106 is configured to have a bandgap greater than the bandgap of the insulating layer 104. Since the layer 106 comprises the two sub-layers 106a and 106b previously described (or a plurality thereof), it allows to combine the advantages of high bandgap (e.g., the Al₂O₃ bandgap which may be comprised between 7 and 9 eV) and high dielectric constant (e.g., the HfO₂ dielectric constant which is about 20).

According to the invention, in the stack 100:
the first insulating layer 102 has a first bandgap value and a first thickness;
the second insulating layer 104 has a second bandgap value lower than the first bandgap value and a second thickness greater than the first thickness; and
the third insulating layer 106 has a third bandgap value comprised between the first and the second bandgap values and a third thickness greater than the second thickness.

Further, in the stack 100: the first insulating layer 102 has a thickness comprised between 0.5 nm and 1 nm, extremes included, and a bandgap between 7 and 9 eV, extremes included; the insulating layer 102 is of SiO₂ or of one of the materials indicated above for this layer;
the second insulating layer 104 has a thickness comprised between 1.5 nm and 2.5 nm, extremes included, and a bandgap between 4 and 6 eV, extremes included; the insulating layer 104 is of HfO₂ or of one of the materials indicated above for this layer;
the third insulating layer 106 has a thickness comprised between 10 nm and 100 nm, extremes included, and a bandgap between 7 and 8.5 eV, extremes included; the insulating layer 106 is a multilayer comprising the layer 106a and the layer 106b, or a succession of a plurality of layers 106a and 106b alternated to each other.

In one embodiment of the stack 100 in part not falling under the scope of the claimed invention:
the first insulating layer 102 has a thickness, along Z, comprised between 0.5 nm and 5 nm;
the second insulating layer 104 has a thickness, along Z, comprised between 0.5 nm and 5 nm; and
the third insulating layer 106 has a thickness, along Z, comprised between 10 nm and 100 nm.

In one embodiment, the stack 100 comprises:
the first insulating layer 102, in particular of Silicon Oxide (SiO₂), having a thickness, along Z, comprised between 0.5 nm and 5 nm; the second insulating layer 104 on the first insulating layer 102, in particular of Hafnium Oxide (HfO₂), having a thickness, along Z, comprised between 0.5 nm and 5 nm; the third insulating layer 106 on the second insulating layer 104, in particular of an alloy including aluminum (e.g.: Al₂O₃, AlN, AlON), having a thickness, along Z, comprised between 10 nm and 100 nm. The third insulating layer 106 may be formed by a plurality of (e.g., two) sub-layers 106a, 106b, wherein the sub-layer 106a is of Aluminum Oxide (e.g., Al₂O₃) and the sub-layer 106b is of a Hafnium Oxide (e.g., HfO₂).

The materials of the layers 102, 104 and 106 of all of the embodiments mentioned above are not limiting the invention. In particular, the first insulating layer 102 may alternatively be of Al₂O₃, SiN or AlN; the second insulating layer 104 may alternatively be of HfSiOₓ, ZrO₂, ZrSiOₓ; the sub-layer 106a of the third insulating layer 106 may alternatively be of AlSiOₓ and/or the sub-layer 106b may alternatively be of HfSiOₓ. Other materials can be used provided that such layers have the respective first, second and third bandgap values, as mentioned above.

The above mentioned embodiments may be combined together, as apparent to those skilled in the art.

The stack 100 according to the present invention, with respect to a single layer of a high-k material or of a set of sub-layers other than that described herein, allows to combine the advantages of high bandgap of the insulating layer 106 and the advantages of high dielectric constant of the insulating layer 104.

The stack 100 is steady, and has the aforementioned properties, when the materials forming it are amorphous (and non-crystalline). A further additional positive effect is that the proposed structure has a higher capacitance with respect to a gate dielectric of sole Silicon Oxide, allowing to have a higher RC constant, consequently limiting ringing phenomena induced by the fast switching of the MOSFET device 20.

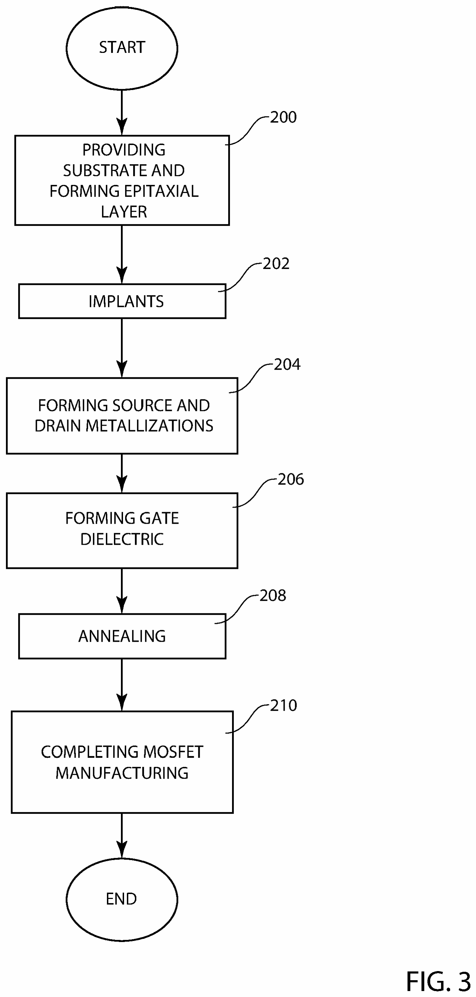

With reference to the flowchart of Figure 3, manufacturing steps of the MOSFET device 20 are now illustrated, with particular reference to the formation of the stack 100.

Step 200 comprises steps, known per se and therefore not described in detail, of forming the semiconductor body 48, including providing the substrate 36 and forming, on the substrate 36, the epitaxial layer 38 (by epitaxy).

Then, step 202, doping species implants are performed for forming the implanted regions 45 (body wells) and 26 (source regions). An annealing step is then performed (e.g., at a temperature comprised between 1600 and 1800°C) for activating the dopants of the body 45 and source 26 implanted regions.

Then, step 204, the method proceeds with the formation of the source 59 and drain 27 metallizations (which form the respective ohmic contacts). This step includes depositing a metal layer (typically Ni, Ti, or a combination of Ni/Ti) at the source/body implants. This step is followed by a suitable high-temperature annealing (rapid thermal process, between 800°C and 1100°C for a time interval from 1 minute to 120 minutes) . This allows the ohmic contacts (e.g., of Nickel Silicide, Ni₂Si, in the event that the metal layer is of Ni) to be formed, by chemical reaction between the deposited metal and the Silicon present in the semiconductor body 48 (which, in this embodiment, is of SiC). In fact, the deposited metal reacts where it is in contact with the surface material of the semiconductor body 48, forming the ohmic contact.

Then, step 206, steps are performed for forming the stack 100.

In particular, the first insulating layer 102 is formed by depositing a Silicon Oxide layer, on the semiconductor body 48 (more precisely on the epitaxial layer 38) between the source metallizations 59. This step may be implemented by thermal oxidation or by bath in oxidizing solution (H₂O₂). This step is performed at temperatures comprised between 900°C and 1400°C for times that may vary between 30 s and 5 minutes depending on the temperature. The baths in aqueous solution of hydrogen peroxide may be carried out in a range of temperatures comprised between room temperature (25°C) up to temperatures of 80-90 °C for a duration that may reach 120 minutes.

Alternatively, the insulating layer 102 may be deposited by ALD ("Atomic Layer deposition") technique.

Then, the second insulating layer 104 is formed, on the first insulating layer 102, also by ALD technique. In one embodiment, the second insulating layer 104 is of HfO₂ and may be deposited by a thermal process or Plasma, using the parameters according to the following table:

| Method | Oxidizing source(O) | Purging flow | Hf precursor pulsing period | Oxygen pulsing period | Purging period | Deposition temperature |
|---|---|---|---|---|---|---|
| Thermal | H₂O | N₂ (1-100 sccm) | 10-200 ms | 10-20 ms | 10-30 s | 200-300 °C |
| Plasma | O₂-plasma | N₂ (1-100 sccm) | 50-300 ms | 1-5 ms | 10-30 s | 200-300 °C |

Then, the third insulating layer 106 is formed, on the second insulating layer 106, also by ALD technique. In one embodiment, the third insulating layer 106 is of Al₂O₃ and may be deposited by a thermal process or Plasma, using the parameters according to the following table:

| Method | Oxidizing source(O) | Purging flow | Hf precursor pulsing period | Oxygen pulsing period | Purging period | Deposition temperature |
|---|---|---|---|---|---|---|
| Thermal | H₂O | N₂ (1-100 sccm) | 10-200 ms | 10-50 ms | 2-5 s | 200-300 °C |
| Plasma | O₂-plasma | N₂ (1-100 sccm) | 50-300 ms | 0.1-1 s | 2-5 s | 200-300 °C |

As an alternative to deposition by ALD, one or all of the insulating layers 102, 104, 106 may be deposited by CVD technique, or reactive ion sputtering.

Then, step 208, a post-deposition annealing step is performed, in an environment containing oxygen, or in an inert environment such as Argon and/or Nitrogen.

Finally, step 210, the remaining steps are performed to complete the formation of the MOSFET device 20, including the formation of the gate conductive terminal (gate metallization 53 and insulating layer 56), in a per se known manner. The formation of the source terminal is also completed, forming the metallization 58.

With reference to the gate dielectric (stack 100), the latter is designed in such a way as to have a high density of electron traps.

Further specific treatments, as said, may allow the formation of electron traps. Such treatments include:
a. Annealing process in a reducing environment, to increase the oxygen vacancies (e.g., in a chamber with a gas from among N₂, Ar, NH₃).
b. Application of a voltage (e.g., positive) to the gate dielectric to allow an accumulation of charges in the insulating layer.
c. In-situ doping, through the introduction of electro-negative atomic species (e.g., fluorine).

The negative charges that occur in the gate dielectric, as a consequence of what has been discussed above, compensate for the reduction of the threshold voltage Vₜₕ of the device as the channel resistance decreases. A MOSFET device is thus obtained having a high threshold voltage Vₜₕ and a low R_{ON}.

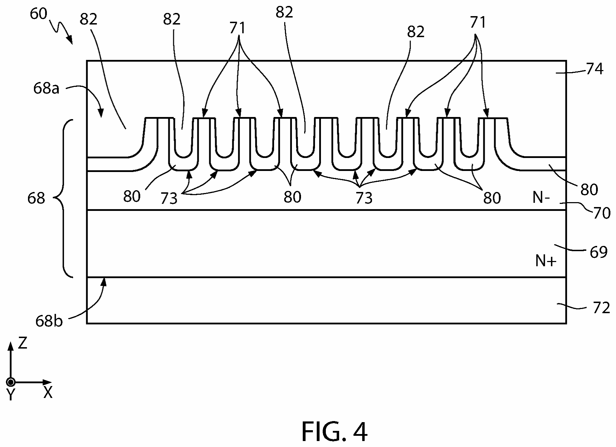

Figure 4 shows a lateral sectional view, in a Cartesian (triaxial) reference system of axes X, Y, Z, a Schottky device (diode) 60.

The Schottky device 60 includes a semiconductor body 68, in particular of SiC, more particularly of 3C-SiC; however, what described herein also applies to other SiC polytypes, for example 4H-SiC. The semiconductor body 68 has a first and a second face 68a, 68b opposite to each other along the direction of the Z axis. In particular, in the present embodiment, the term "semiconductor body" means a structural element which may comprise one or more epitaxial layers grown on a base substrate. Figure 4 illustrates, according to an embodiment, a semiconductor body 68 including a base substrate 69 having an epitaxially grown structural layer 70 extending thereon, acting as a drift layer. The substrate 69 has a first conductivity, here of N-type, and doping for example comprised between 1**·**10¹⁸ cm⁻³ and 5**·**10¹⁹ cm⁻³. The structural layer 70 has the first conductivity and doping lower than the doping of the substrate 69, for example comprised between 1**·**10¹⁴ cm⁻³ and 1**·**10¹⁷ cm⁻³.

The Schottky device 60 further includes a cathode terminal 72, of metal material, which extends on the second face 68b of the semiconductor body 68; and an anode terminal 74, of metal material, which extends on the first face 68a of the semiconductor body 68. In use, by suitable biasing, a conductive channel is established between the anode terminal and the cathode terminal.

The Schottky device 60 has one or more trenches 73 extending in depth into the semiconductor body 68, in particular into the drift layer 70, along a main direction parallel to the Z axis. Exemplarily, each trench 73 has a depth d1, measured from the first face 68a towards the second face 68b, having a value comprised between 100 nm and 1000 nm. In the event that multiple trenches 73 are present, each trench 73 is spaced from a trench 73 immediately adjacent, along the direction of the X axis, from a portion of the structural layer 70. This portion of the structural layer 70 has an extension d2, along the direction of the X axis, having a value comprised, for example, between 100 nm and 5000 nm.

Each trench 73 is partially filled by a dielectric or insulating layer 80, which covers the side walls and the bottom of each respective trench 73. Furthermore, the filling of each trench 73 is completed by conductive portions 82 of the anode terminal 74 which penetrate and/or cover the trenches 73. Each of the portions 82 is therefore insulated from the structural layer 70 by a respective insulating layer 80.

The insulating layer 80 is a multilayer, or stack, of the same type as the stack 100 previously described and formed according to the same process steps (described in step 206 of Figure 3). Furthermore, the insulating layer 80 is designed in a manner similar to what has been described with reference to the dielectric layer 52 (stack 100), i.e. in such a way as to present a high number of traps for the majority carriers (here, electrons).

Schottky junctions 71 are formed by the plurality of metal-semiconductor junctions present at the interface between the drift layer 70 and the metal layer of the anode metallization 74. In particular, the Schottky junctions 71 (semiconductor-metal) are formed by portions of the drift layer 70 (N-doped) in direct electrical contact with respective portions of the anode metallization 74.

The presence of a net negative charge at the insulating layer 80 allows balancing the positive charges at the interface with the structural layer 70 and thus allows the interdiction characteristics of the diode 60 to be optimized. In particular, the surface depletion layer may be optimized by modifying both the switch-on voltage of the diode and the interdiction characteristics for negative biasing on the Schottky contact.

From an examination of the characteristics of the invention made according to the present invention, the advantages that it affords are evident.

According to the present invention it is in fact possible to reduce the thermal budget required for the manufacturing of the gate terminal, increase the reliability of the gate dielectric, reduce the R_{ON} and increase the Vₜₕ. These advantages are, at least in part, obtained owing to the high-permittivity high-k gate dielectric, whose properties may be adjusted by the process described above.

Finally, it is clear that modifications and variations may be made to what has been described and illustrated herein, without thereby departing from the scope of the present invention, as defined in the attached claims.

For example, the present invention may be applied to devices based on a SiC polytype other than 3C-SiC or 4H-SiC, in general transistors and diodes.

Furthermore, the present invention may be applied to devices based on a material other than SiC, for example GaN and AlGaN/GaN (normally-off HEMTs).

Furthermore, the present invention finds applications in various electronic devices other than those described in the aforementioned particular embodiments, for example VMOS ("Vertical-channel MOS"), DMOS ("Diffused MOS"), CMOS ("Complementary MOS").

The present invention is also applicable to horizontal-channel devices.

## Claims

1. An electronic device (20; 60) comprising:
a semiconductor body (48; 68), in particular of Silicon Carbide, having a first (48a; 68a) and a second face (48b; 68b), opposite to each other along a first direction (Z);
an electrical terminal (G; 82, 74) at the first face (48b; 68b), including a conductive layer (53) and an electrical insulation region (52; 80), the electrical insulation region (52; 80) extending between the semiconductor body (48; 68) and the conductive layer (53),
wherein said electrical insulation region (52; 80) is a multilayer comprising:
a first insulating layer (102) in contact with the semiconductor body, having a first bandgap value and a first thickness, configured to be traversed by the tunnel effect, during use, by electric charge carriers coming from the semiconductor body (48; 68);
a second insulating layer (104) on the first insulating layer (102), having a second bandgap value lower than the first bandgap value and a second thickness configured to form a potential well for said electric charge carriers; and
a third insulating layer (106) on the second insulating layer (104), having a third bandgap value comprised between the first and the second bandgap values and a third thickness,
**characterized in that**:
the second thickness is greater than the first thickness and the third thickness is greater than the second thickness;
the first insulating layer (102) has a thickness comprised between 0.5 nm and 1 nm and a bandgap between 7 and 9 eV;
the second insulating layer (104) has a thickness comprised between 1.5 nm and 2.5 nm and a bandgap between 4 and 6 eV; and
the third insulating layer (106) has a thickness comprised between 10 and 100 nm and a bandgap between 7 and 8.5 eV.

2. The electronic device according to claim 1, wherein:
the first insulating layer (102) is of one from among: SiN, SiO₂, AlN;
the second insulating layer (104) is of one from among: HfO₂, HfSiOₓ, ZrO₂, ZrSiOₓ; and
the third insulating layer (106) includes two or more alternating layers of an Aluminum Oxide and a Hafnium Oxide.

3. The electronic device according to claim 2, wherein the third insulating layer (106) includes two or more alternating layers of Al₂O₃ and HfO₂, or two or more alternating layers of AlSiOₓ and HfSiOₓ.

4. The electronic device according to anyone of the preceding claims, further comprising a channel region (38, 36; 69, 70) in said semiconductor body (48; 68), configured to accommodate, in use, an electric current,
said electrical insulation region (52; 80) extending at said channel region.

5. The electronic device according to claim 4, having positive charge carriers at said first face (48a; 68a) defining a positive interface charge, said electrical insulation region (52; 80) being designed in such a way as to have trap states of electrons, which generate a negative charge such as to balance, at least in part, said positive interface charge.

6. The electronic device (20) according to anyone of the preceding claims, wherein said electronic device is a MOSFET comprising a source terminal (S, 26, 59) and a drain terminal (D, 27),
said electrical terminal being a gate terminal (G, 53) of the MOSFET, the conductive layer being a gate metallization (53), and the electrical insulation region (52) forming, as a whole, a gate dielectric.

7. The electronic device (60) according to anyone of claims 1-5, wherein said electronic device is a diode and includes:
a cathode terminal (72) extending at the second face (68b) of the semiconductor body (68);
at least one trench (73) extending from the first face (68a) towards the second face (68b), said electrical insulation region (80) extending into said trench (73);
wherein said electrical terminal forms an anode terminal (74) of the diode and includes a metal layer having a portion (82) extending into said trench (73),
said electrical insulation region (80) extending between said portion (82) of the anode terminal (74) and the semiconductor body (68).

8. The electronic device (60) according to claim 7, wherein the diode is a Schottky diode comprising at least one metal-semiconductor junction formed by an electrical contact region between the anode terminal (74) and the semiconductor body (68) laterally to said trench (73).

9. A method of manufacturing an electronic device (20; 60) comprising the steps of:
providing a semiconductor body (48; 68), in particular of Silicon Carbide, having a first (48a; 68a) and a second face (48b; 68b), opposite to each other along a first direction (Z);
forming an electrical terminal (G; 82, 74) at the first face (48b; 68b), including forming a conductive layer (53) and an electrical insulation region (52; 80) between the conductive layer (53) and the semiconductor body (48; 68), configured to electrically insulate the electrical terminal **(G;** 82, 74) from the semiconductor body (48; 68),
wherein the step of forming said electrical insulation region (52; 80) comprises forming a multilayer, including:
forming a first insulating layer (102) in contact with the semiconductor body, having a first bandgap value and a first thickness, configured to be traversed, by tunnel effect, during use, by electric charge carriers coming from the semiconductor body (48; 68);
forming a second insulating layer (104) on the first insulating layer (102), having a second bandgap value lower than the first bandgap value and a second thickness, configured to form a potential well for said electric charge carriers; and
forming a third insulating layer (106) on the second insulating layer (104), having a third bandgap value comprised between the first and the second bandgap values and a third thickness,
**characterized in that**
the second thickness is greater than the first thickness and the third thickness is greater than the second thickness;
the first insulating layer (102) has a thickness comprised between 0.5 nm and 1 nm and a bandgap between 7 and 9 eV;
the second insulating layer (104) has a thickness comprised between 1.5 nm and 2.5 nm and a bandgap between 4 and 6 eV; and
the third insulating layer (106) has a thickness comprised between 10 and 100 nm and a bandgap between 7 and 8.5 eV.

10. The method according to claim 9, wherein:
the first insulating layer (102) is of one from among: SiN, SiO₂, AlN;
the second insulating layer (104) is of one from among: HfO₂, HfSiOₓ, ZrO₂, ZrSiOₓ; and
the third insulating layer (106) includes two or more alternating layers of an Aluminum Oxide and a Hafnium Oxide.

11. The method according to claim 10, wherein the third insulating layer (106) includes two or more alternating layers of Al₂O₃ and HfO2, or two or more alternating layers of AlSiOx and HfSiOx.

12. The method according to any of claims 9-11, wherein forming the second and the third insulating layers (104, 106) comprises performing respective depositions by ALD technique.

13. The method according to anyone of claims 9-12, further comprising a channel region (38, 36; 69, 70) in said semiconductor body (48; 68), configured to accommodate, in use, an electric current,
said electrical insulation region (52; 80) being formed at said channel region.

14. The method according to anyone of claims 9-13, wherein said electronic device is a MOSFET,
the manufacturing steps further comprising forming a source terminal (S, 26, 59) and a drain terminal (D, 27) of the MOSFET,
said electrical terminal being a gate terminal (G, 53) of the MOSFET, the conductive layer (53) being a gate metallization (53), and the electrical insulation region (52) forming, as a whole, a gate dielectric.

15. The method according to anyone of claims 9-13, wherein said electronic device is a diode, the manufacturing steps further comprising:
forming a cathode terminal (72) extending at the second face (68b) of the semiconductor body (68);
forming at least one trench (73) extending from the first face (68a) towards the second face (68b), said electrical insulation region (80) extending into said trench (73);
wherein said electrical terminal is an anode terminal (74) of the diode and includes a metal layer having a portion (82) extending into said trench (73),
said electrical insulation region (80) extending between said portion (82) of the anode terminal (74) and the semiconductor body (68).

## Patentansprüche

1. Elektronische Vorrichtung (20; 60), umfassend:
einen Halbleiterkörper (48; 68), insbesondere aus Siliziumkarbid, mit einer ersten (48a; 68a) und einer zweiten Fläche (48b; 68b), die einander entlang einer ersten Richtung (Z) gegenüberliegen;
einen elektrischen Anschluss (G; 82, 74) an der ersten Fläche (48b; 68b), einschließlich einer leitfähigen Schicht (53) und eines elektrischen Isolationsbereichs (52; 80), wobei sich der elektrische Isolationsbereich (52; 80) zwischen dem Halbleiterkörper (48; 68) und der leitfähigen Schicht (53) erstreckt,
wobei der elektrische Isolationsbereich (52; 80) eine Mehrschicht ist, umfassend:
eine erste Isolierschicht (102) in Kontakt mit dem Halbleiterkörper, die einen ersten Bandabstandswert und eine erste Dicke aufweist und so eingerichtet ist, dass sie während der Verwendung von elektrischen Ladungsträgern, die vom Halbleiterkörper (48; 68) kommen, durchquert wird;
eine zweite Isolierschicht (104) auf der ersten Isolierschicht (102), die einen zweiten Bandabstandswert, der niedriger ist als der erste Bandabstandswert, und eine zweite Dicke aufweist, die so eingerichtet ist, dass sie eine Potenzialmulde für die elektrischen Ladungsträger bildet; und
eine dritte Isolierschicht (106) auf der zweiten Isolierschicht (104), die einen dritten Bandabstandswert, der zwischen dem ersten und dem zweiten Bandabstandswert, sowie eine dritte Dicke aufweist,
**dadurch gekennzeichnet, dass**:
die zweite Dicke größer ist als die erste Dicke und die dritte Dicke größer ist als die zweite Dicke;
die erste Isolierschicht (102) eine Dicke zwischen 0,5 nm und 1 nm und einen Bandabstand zwischen 7 und 9 eV aufweist; die zweite Isolierschicht (104) eine Dicke zwischen 1,5 nm und 2,5 nm und einen Bandabstand zwischen 4 und 6 eV aufweist; und
die dritte Isolierschicht (106) eine Dicke zwischen 10 und 100 nm und einen Bandabstand zwischen 7 und 8,5 eV aufweist.

2. Elektronische Vorrichtung nach Anspruch 1, wobei: die erste Isolierschicht (102) aus einem von Folgendem besteht:
SiN, SiO₂, AlN;
die zweite Isolierschicht (104) aus einem von Folgendem besteht: HfO₂, HfSiOₓ, ZrO₂, ZrSiOₓ; und
die dritte Isolierschicht (106) zwei oder mehr abwechselnde Schichten aus einem Aluminiumoxid und einem Hafniumoxid einschließt.

3. Elektronische Vorrichtung nach Anspruch 2, wobei die dritte Isolierschicht (106) zwei oder mehr abwechselnde Schichten aus Al₂O₃ und HfO₂ oder zwei oder mehr abwechselnde Schichten aus AlSiOₓ und HfSiOₓ einschließt.

4. Elektronische Vorrichtung nach einem der vorhergehenden Ansprüche, die ferner einen Kanalbereich (38, 36; 69, 70) in dem Halbleiterkörper (48; 68) umfasst, der so eingerichtet ist, dass er im Betrieb einen elektrischen Strom aufnimmt,
wobei sich der elektrische Isolationsbereich (52; 80) an dem Kanalbereich erstreckt.

5. Elektronische Vorrichtung nach Anspruch 4, die positive Ladungsträger an der ersten Fläche (48a; 68a) aufweist, die eine positive Schnittstellenladung definieren, wobei der elektrische Isolationsbereich (52; 80) so ausgebildet ist, dass er Fangzustände von Elektronen aufweist, die eine negative Ladung erzeugen, um die positive Schnittstellenladung mindestens teilweise auszugleichen.

6. Elektronische Vorrichtung (20) nach einem der vorhergehenden Ansprüche, wobei die elektronische Vorrichtung ein MOSFET ist, der einen Source-Anschluss (S, 26, 59) und einen Drain-Anschluss (D, 27) umfasst,
wobei der elektrische Anschluss ein Gate-Anschluss (G, 53) des MOSFET ist, die leitfähige Schicht eine Gate-Metallisierung (53) ist und der elektrische Isolationsbereich (52) als Ganzes ein Gate-Dielektrikum bildet.

7. Elektronische Vorrichtung (60) nach einem der Ansprüche 1 bis 5, wobei die elektronische Vorrichtung eine Diode ist und Folgendes einschließt:
einen Kathodenanschluss (72), der sich an der zweiten Fläche (68b) des Halbleiterkörpers (68) erstreckt;
mindestens einen Graben (73), der sich von der ersten Fläche (68a) in Richtung der zweiten Fläche (68b) erstreckt, wobei sich der elektrische Isolationsbereich (80) in den Graben (73) hinein erstreckt;
wobei der elektrische Anschluss einen Anodenanschluss (74) der Diode bildet und eine Metallschicht einschließt, die einen Abschnitt (82) aufweist, der sich in den Graben (73) hinein erstreckt,
wobei sich der elektrische Isolationsbereich (80) zwischen dem Abschnitt (82) des Anodenanschlusses (74) und dem Halbleiterkörper (68) erstreckt.

8. Elektronische Vorrichtung (60) nach Anspruch 7, wobei die Diode eine Schottky-Diode ist, die mindestens eine Metall-Halbleiter-Verbindung umfasst, die durch einen elektrischen Kontaktbereich zwischen dem Anodenanschluss (74) und dem Halbleiterkörper (68) seitlich des Grabens (73) gebildet wird.

9. Verfahren zum Herstellen einer elektronischen Vorrichtung (20; 60), das die folgenden Schritte umfasst:
Bereitstellen eines Halbleiterkörpers (48; 68), insbesondere aus Siliziumkarbid, mit einer ersten (48a; 68a) und einer zweiten Fläche (48b; 68b), die einander entlang einer ersten Richtung (Z) gegenüberliegen;
Bilden eines elektrischen Anschlusses (G; 82, 74) an der ersten Fläche (48b; 68b), einschließlich des Bildens einer leitfähigen Schicht (53) und eines elektrischen Isolationsbereichs (52; 80) zwischen der leitfähigen Schicht (53) und dem Halbleiterkörper (48; 68), der so eingerichtet ist, dass der den elektrischen Anschluss (G; 82, 74) vom Halbleiterkörper (48; 68) elektrisch isoliert, wobei der Schritt des Bildens des elektrischen Isolationsbereichs (52; 80) das Bilden einer Mehrschicht umfasst, einschließlich:
Bilden einer ersten Isolierschicht (102) in Kontakt mit dem Halbleiterkörper, die einen ersten Bandabstandswert und eine erste Dicke aufweist und so eingerichtet ist, dass sie während der Verwendung von elektrischen Ladungsträgern, die vom Halbleiterkörper (48; 68) kommen, durchquert wird;
Bilden einer zweiten Isolierschicht (104) auf der ersten Isolierschicht (102), die einen zweiten Bandabstandswert, der niedriger ist als der erste Bandabstandswert, und eine zweite Dicke aufweist, die so eingerichtet ist, dass sie eine Potenzialmulde für die elektrischen Ladungsträger bildet; und
Bilden einer dritten Isolierschicht (106) auf der zweiten Isolierschicht (104), die einen dritten Bandabstandswert, der zwischen dem ersten und dem zweiten Bandabstandswert, sowie eine dritte Dicke aufweist, **dadurch gekennzeichnet, dass**
die zweite Dicke größer ist als die erste Dicke und die dritte Dicke größer ist als die zweite Dicke;
die erste Isolierschicht (102) eine Dicke zwischen 0,5 nm und 1 nm und einen Bandabstand zwischen 7 und 9 eV aufweist;
die zweite Isolierschicht (104) eine Dicke zwischen 1,5 nm und 2,5 nm und einen Bandabstand zwischen 4 und 6 eV aufweist; und
die dritte Isolierschicht (106) eine Dicke zwischen 10 und 100 nm und einen Bandabstand zwischen 7 und 8,5 eV aufweist.

10. Verfahren nach Anspruch 9, wobei:
die erste Isolierschicht (102) aus einem von Folgendem besteht:
SiN, SiO₂, AlN;
die zweite Isolierschicht (104) aus einem von Folgendem besteht: HfO₂, HfSiOₓ, ZrO₂, ZrSiOₓ; und
die dritte Isolierschicht (106) zwei oder mehr abwechselnde Schichten aus einem Aluminiumoxid und einem Hafniumoxid einschließt.

11. Verfahren nach Anspruch 10, wobei die dritte Isolierschicht (106) zwei oder mehr abwechselnde Schichten aus Al₂O₃ und HfO2 oder zwei oder mehr abwechselnde Schichten aus AlSiOx und HfSiOx einschließt.

12. Verfahren nach einem der Ansprüche 9 bis 11, wobei das Bilden der zweiten und der dritten Isolierschicht (104, 106) das Durchführen jeweiliger Abscheidungen mittels ALD-Technik umfasst.

13. Verfahren nach einem der Ansprüche 9 bis 12, ferner umfassend einen Kanalbereich (38, 36; 69, 70) in dem Halbleiterkörper (48; 68), der so eingerichtet ist, dass er im Betrieb einen elektrischen Strom aufnimmt,
wobei der elektrische Isolationsbereich (52; 80) an dem Kanalbereich ausgebildet ist.

14. Verfahren nach einem der Ansprüche 9 bis 13, wobei die elektronische Vorrichtung ein MOSFET ist,
wobei die Herstellungsschritte ferner das Bilden eines Source-Anschlusses (S, 26, 59) und eines Drain-Anschlusses (D, 27) des MOSFET umfassen,
wobei der elektrische Anschluss ein Gate-Anschluss (G, 53) des MOSFET ist, die leitfähige Schicht (53) eine Gate-Metallisierung (53) ist und der elektrische Isolationsbereich (52) als Ganzes ein Gate-Dielektrikum bildet.

15. Verfahren nach einem der Ansprüche 9 bis 13, wobei die elektronische Vorrichtung eine Diode ist, wobei die Herstellungsschritte ferner Folgendes umfassen:
Bilden eines Kathodenanschlusses (72), der sich an der zweiten Fläche (68b) des Halbleiterkörpers (68) erstreckt;
Bilden mindestens eines Grabens (73), der sich von der ersten Fläche (68a) in Richtung der zweiten Fläche (68b) erstreckt, wobei sich der elektrische Isolationsbereich (80) in den Graben (73) hinein erstreckt;
wobei der elektrische Anschluss ein Anodenanschluss (74) der Diode ist und eine Metallschicht einschließt, die einen Abschnitt (82) aufweist, der sich in den Graben (73) hinein erstreckt,
wobei sich der elektrische Isolationsbereich (80) zwischen dem Abschnitt (82) des Anodenanschlusses (74) und dem Halbleiterkörper (68) erstreckt.

## Revendications

1. Dispositif électronique (20 ; 60) comprenant :
un corps semiconducteur (48 ; 68), en particulier en carbure de silicium, ayant une première (48a ; 68a) et une deuxième face (48b ; 68b), opposées l'une à l'autre le long d'une première direction (Z) ;
une borne électrique (G ; 82, 74) sur la première face (48b ; 68b), comportant une couche conductrice (53) et une région d'isolation électrique (52 ; 80), la région d'isolation électrique (52 ; 80) s'étendant entre le corps semiconducteur (48 ; 68) et la couche conductrice (53),
dans lequel ladite région d'isolation électrique (52 ; 80) est une couche multiple comprenant :
une première couche isolante (102) en contact avec le corps semiconducteur, ayant une première valeur de bande interdite et une première épaisseur, configurée pour être traversée par l'effet tunnel, en utilisation, par des porteurs de charge électrique venant du corps semiconducteur (48 ; 68) ;
une deuxième couche isolante (104) sur la première couche isolante (102), ayant une deuxième valeur de bande interdite inférieure à la première valeur de bande interdite et une deuxième épaisseur configurée pour former un puits de potentiel pour lesdits porteurs de charge électrique ; et
une troisième couche isolante (106) sur la deuxième couche isolante (104), ayant une troisième valeur de bande interdite comprise entre les première et deuxième valeurs de bande interdite et une troisième épaisseur,
**caractérisé en ce que** :
la deuxième épaisseur est plus grande que la première épaisseur et la troisième épaisseur est plus grande que la deuxième épaisseur ;
la première couche isolante (102) a une épaisseur comprise entre 0,5 nm et 1 nm et une bande interdite entre 7 et 9 eV ;
la deuxième couche isolante (104) a une épaisseur comprise entre 1,5 nm et 2,5 nm et une bande interdite entre 4 et 6 eV ; et
la troisième couche isolante (106) a une épaisseur comprise entre 10 et 100 nm et une bande interdite entre 7 et 8,5 eV.

2. Dispositif électronique selon la revendication 1, dans lequel :
la première couche isolante (102) est choisie parmi : SiN, SiO₂, AlN ;
la deuxième couche isolante (104) est choisie parmi : HfO₂, HfSiOₓ, ZrO₂, ZrSiOₓ ; et
la troisième couche isolante (106) comprend deux couches alternées ou plus d'un oxyde d'aluminium et d'un oxyde d'hafnium.

3. Dispositif électronique selon la revendication 2, dans lequel la troisième couche isolante (106) comprend deux couches alternées ou plus d'Al₂O₃ et d'HfO₂, ou deux couches alternées ou plus d'AlSiOₓ et d'HfSiOₓ.

4. Dispositif électronique selon l'une quelconque des revendications précédentes, comprenant en outre une région de canal (38, 36 ; 69, 70) dans ledit corps semiconducteur (48 ; 68), configurée pour recevoir, en utilisation, un courant électrique,
ladite région d'isolation électrique (52 ; 80) s'étendant au niveau de ladite région de canal.

5. Dispositif électronique selon la revendication 4, ayant des porteurs de charge positive sur ladite première face (48a ; 68a) définissant une charge d'interface positive, ladite région d'isolation électrique (52 ; 80) étant conçue de manière à avoir des états de piège des électrons, qui génèrent une charge négative afin de contrebalancer, au moins en partie, ladite charge d'interface positive.

6. Dispositif électronique (20) selon l'une quelconque des revendications précédentes, dans lequel ledit dispositif électronique est un transistor MOSFET comprenant une borne de source (S, 26, 59) et une borne de drain (D, 27),
ladite borne électrique étant une borne de grille (G, 53) du transistor MOSFET, la couche conductrice étant une métallisation de grille (53), et la région d'isolation électrique (52) formant dans son ensemble un diélectrique de grille.

7. Dispositif électronique (60) selon l'une quelconque des revendications 1 à 5, dans lequel ledit dispositif électronique est une diode et comprend :
une borne de cathode (72) s'étendant au niveau de la deuxième face (68b) du corps semiconducteur (68) ;
au moins une tranchée (73) s'étendant de la première face (68a) vers la deuxième face (68b), ladite région d'isolation électrique (80) s'étendant dans ladite tranchée (73) ;
dans lequel ladite borne électrique forme une borne d'anode (74) de la diode et comporte une couche de métal ayant une partie (82) s'étendant dans ladite tranchée (73),
ladite région d'isolation électrique (80) s'étendant entre ladite partie (82) de la borne d'anode (74) et le corps semiconducteur (68).

8. Dispositif électronique (60) selon la revendication 7, dans lequel la diode est une diode Schottky comprenant au moins une jonction métal-semiconducteur formée par une région de contact électrique entre la borne d'anode (74) et le corps semiconducteur (68) latéralement par rapport à ladite tranchée (73).

9. Procédé de fabrication d'un dispositif électronique (20 ; 60) comprenant les étapes suivantes :
fournir un corps semiconducteur (48 ; 68), en particulier en carbure de silicium, ayant une première (48a ; 68a) et une deuxième face (48b ; 68b), opposées l'une à l'autre le long d'une première direction (Z) ;
former une borne électrique (G ; 82, 74) sur la première face (48b ; 68b), comprenant la formation d'une couche conductrice (53) et d'une région d'isolation électrique (52 ; 80) entre la couche conductrice (53) et le corps semiconducteur (48 ; 68), configurée pour isoler électriquement la borne électrique (G ; 82, 74) du corps semiconducteur (48 ; 68),
dans lequel l'étape de formation de ladite région d'isolation électrique (52 ; 80) comprend la formation d'une couche multiple, comprenant les opérations suivantes :
former une première couche isolante (102) en contact avec le corps semiconducteur, ayant une première valeur de bande interdite et une première épaisseur, configurée pour être traversée, par effet tunnel, en utilisation, par des porteurs de charge électrique venant du corps semiconducteur (48 ; 68) ;
former une deuxième couche isolante (104) sur la première couche isolante (102), ayant une deuxième valeur de bande interdite inférieure à la première valeur de bande interdite et une deuxième épaisseur, configurée pour former un puits de potentiel pour lesdits porteurs de charge électrique ; et
former une troisième couche isolante (106) sur la deuxième couche isolante (104), ayant une troisième valeur de bande interdite comprise entre les première et deuxième valeurs de bande interdite et une troisième épaisseur,
**caractérisé en ce que** :
la deuxième épaisseur est plus grande que la première épaisseur et la troisième épaisseur est plus grande que la deuxième épaisseur ;
la première couche isolante (102) a une épaisseur comprise entre 0,5 nm et 1 nm et une bande interdite entre 7 et 9 eV ;
la deuxième couche isolante (104) a une épaisseur comprise entre 1,5 nm et 2,5 nm et une bande interdite entre 4 et 6 eV ; et
la troisième couche isolante (106) a une épaisseur comprise entre 10 et 100 nm et une bande interdite entre 7 et 8,5 eV.

10. Procédé selon la revendication 9, dans lequel :
la première couche isolante (102) est choisie parmi : SiN, SiO₂, AlN ;
la deuxième couche isolante (104) est choisie parmi : HfO₂, HfSiOₓ, ZrO₂, ZrSiOₓ ; et
la troisième couche isolante (106) comprend deux couches alternées ou plus d'un oxyde d'aluminium et d'un oxyde d'hafnium.

11. Procédé selon la revendication 10, dans lequel la troisième couche isolante (106) comprend deux couches alternées ou plus d'Al₂O₃ et d'HfO₂, ou deux couches alternées ou plus d'AlSiOₓ et d'HfSiOₓ.

12. Procédé selon l'une quelconque des revendications 9 à 11, dans lequel la formation des deuxième et troisième couches isolantes (104, 106) comprend la réalisation de dépôts respectifs par une technique ALD.

13. Procédé selon l'une quelconque des revendications 9 à 12, comprenant en outre une région de canal (38, 36 ; 69, 70) dans ledit corps semiconducteur (48 ; 68), configurée pour recevoir, en utilisation, un courant électrique,
ladite région d'isolation électrique (52 ; 80) étant formée au niveau de ladite région de canal.

14. Procédé selon l'une quelconque des revendications 9 à 13, dans lequel ledit dispositif électronique est un transistor MOSFET,
les étapes de fabrication comprenant en outre la formation d'une borne de source (S, 26, 59) et d'une borne de drain (D, 27) du transistor MOSFET,
ladite borne électrique étant une borne de grille (G, 53) du transistor MOSFET, la couche conductrice (53) étant une métallisation de grille (53), et la région d'isolation électrique (52) formant dans son ensemble un diélectrique de grille.

15. Procédé selon l'une quelconque des revendications 9 à 13, dans lequel ledit dispositif électronique est une diode, les étapes de fabrication comprenant en outre les opérations suivantes :
former une borne de cathode (72) s'étendant au niveau de la deuxième face (68b) du corps semiconducteur (68) ;
former au moins une tranchée (73) s'étendant de la première face (68a) vers la deuxième face (68b), ladite région d'isolation électrique (80) s'étendant dans ladite tranchée (73) ;
dans lequel ladite borne électrique est une borne d'anode (74) de la diode et comporte une couche de métal ayant une partie (82) s'étendant dans ladite tranchée (73),
ladite région d'isolation électrique (80) s'étendant entre ladite partie (82) de la borne d'anode (74) et le corps semiconducteur (68).
